Europäisches Patentamt

European Patent Office

Office européen des brevets

(11) Veröffentlichungsnummer: **0 105 463**
**B1**

(12) **EUROPÄISCHE PATENTSCHRIFT**

(45) Veröffentlichungstag der Patentschrift: **16.01.91**

(51) Int. Cl.⁵: **C 04 B 35/00, C 04 B 35/65,**
**C 04 B 41/51**

(21) Anmeldenummer: **83109681.3**

(22) Anmeldetag: **28.09.83**

(54) Verfahren zur Herstellung eines Werkstoffs aus Silicium.

(30) Priorität: **30.09.82 DE 3236276**

(43) Veröffentlichungstag der Anmeldung:
**18.04.84 Patentblatt 84/16**

(45) Bekanntmachung des Hinweises auf die
Patenterteilung:
**16.01.91 Patentblatt 91/03**

(84) Benannte Vertragsstaaten:
**AT BE CH DE FR GB IT LI NL SE**

(56) Entgegenhaltungen:
**DE-A-2 454 147**
**DE-A-2 615 488**
**DE-B-1 243 400**
**US-A-1 916 836**

(73) Patentinhaber: HELIOTRONIC Forschungs- und
Entwicklungsgesellschaft für Solarzellen-
Grundstoffe mbH
Johannes-Hess-Strasse 24
D-8263 Burghausen (DE)

(72) Erfinder: Dietl, Josef, Dr. Dipl.-Phys.
Am Bärenbach 17
D-8262 Neuötting (DE)
Erfinder: Sirtl, Erhard, Prof. Dr. Dipl.-Chem.
Kiefernweg 11
D-8261 Marktl (DE)
Erfinder: Bauregger, Rolf
Spitzsteinstrasse 19
D-8261 Burgkirchen (DE)
Erfinder: Bildl, Erich
Nr. 46 Post Franking
A-5131 Holzöster (AT)
Erfinder: Dicker, Hermann
Duttendorf 147
A-5122 Ach (AT)
Erfinder: Pichler, Herbert
Holzgassen 22
A-5122 Ach (AT)
Erfinder: Rothlehner, Rudolf
Johannes-Still-Platz 1-3
D-8330 Eggenfelden (DE)

Courier Press, Leamington Spa, England.

# EP 0 105 463 B1

(72) Erfinder: **Seifert, Dieter, Dr. Dipl.-Ing.**
**Siedlungsstrasse 12**
**D-8262 Neuötting (DE)**

**Beschreibung**

Die Erfindung betrifft ein Verfahren zur Herstellung eines Werkstoffes auf Basis von Silicium oder Siliciumlegierungen, bei dem ein Pulver aus elementarem oder legiertem Silicium einer Reaktionsbindung unterworfen wird.

Elementares Silicium ist ein Werkstoff, der bevorzugt in der Halbleitertechnik eingesetzt wird. So werden beispielsweise die Reaktionsräume, in denen Halbleiterscheiben Hochtemperaturprozessen wie Diffusions-, Oxidations- und Epitaxieprozessen unterworfen werden, aus Reinheitsgründen meist aus elementarem Silicium gefertigt. Die dafür geeigneten, polykristallinen Siliciumformkörper werden in der Regel durch Abscheidung des Siliciums aus der Gasphase auf erhitzten, entsprechend geformten Trägerkörpern erhalten, wie etwa in der DE—A—26 18 273 beschrieben. Eine weitere Möglichkeit besteht darin, solche Formkörper mit Diamantsägen aus Siliciumblöcken herauszusägen. Die kostspielige Gasphasenabscheidung wie auch die wegen der Sprödhärte und Bruchempfindlichkeit außerordentlich schwierige Bearbeitung des Siliciums standen bisher jedoch seiner über solche speziellen Anwendungsgebiete hinausgehenden Verbreitung als Werkstoff entgegen.

Aus der DE—B—1 243 400 ist bekannt, Sinterlegierungen aus pulverförmiges Silicium enthaltenden Mischungen, die ggf. mit Essigsäure und Natriumhydroxid angefeuchtet sind, durch Erhitzen auf mindestens 900°C unter Druck herzustellen. In der DE—A—26 15 488 ist ein Verfahren zur Herstellung reaktionsgebundener, Silicium enthaltender Körper beschrieben, bei dem ein Siliciumpulver enthaltendes Material mit Alkalimetallhydroxidlösung angefeuchtet wird, woraufhin in rascher Reaktion die Pulverteilchen durch Alkalisilicatbindung miteinander verwachsen. Das erhaltene Material kommt jedoch wegen des hohen Alkalianteils für Anwendungen nicht in Frage, bei denen es auf hohe Reinheit ankommt.

Aufgabe der Erfindung war es somit, ein Verfahren zur Herstellung eines Werkstoffes zur Verfügung zu stellen, der ausgehend von einem gegenüber dem herkömmlichen polykristallinen Silicium preisgünstigeren, leichter erhältlichen und besser bearbeitbaren Silicium-Grundmaterial die Herstellung von Formkörpern unterschiedlichster Art, Gestalt und Einsatzmöglichkeiten gestattet.

Gelöst wird diese Aufgabe durch ein Verfahren, welches dadurch gekennzeichnet ist, daß das Pulver zum In-Gang-Bringen einer sich selbst unterhaltenden Reaktionsbindung mit einem Silicium ätzenden, von Alkalimetallverbindungen freien Agens angefeuchtet wird.

In dem nach diesem Verfahren erhaltenen Werkstoff liegt das eingesetzte Pulver aus elementarem oder legiertem Silicium in Form eines festen Gefüges vor, in welches ggf. zugesetzte Füllstoffteilchen eingebettet sind. Rasterelektronische Aufnahmen reaktionsgebundenen Pulvers zeigen im Unterschied zum eingesetzten, losen Pulver, daß in den Berührungszonen die einzelnen Pulverkörner über eine bei der Reaktionsbindung entstandene zweite Phase miteinander verwachsen sind. Dies und der analytisch feststellbare, im Vergleich zum Ausgangspulver erhöhte Sauerstoffgehalt, der typisch im Bereich von etwa 5 bis 20 Gew.-%, bezogen auf eingesetztes Silicium, liegt sowie die im Vergleich zu elementarem Silicium deutlich verringerte elektrische Leitfähigkeit lassen vermuten, daß die Reaktionsbindung durch Verknüpfung der einzelnen Pulverteilchen unter Beteiligung von Sauerstoff im Oberflächenbereich bewirkt wird.

Um die Reaktionsbindung in Gang zu bringen, hat sich ein Verfahren als zweckmäßig erwiesen, nach dem das ausgewählte Siliciumpulver mit dem ausgewählten Agens in einer Weise versetzt wird, daß eine gleichmäßig durchfeuchtete Masse entsteht. Diese Masse läßt sich unter Formgebung beispielsweise verstreichen oder vergießen, bis nach einiger Zeit die Reaktionsbindung einsetzt und die Masse sich in der Regel unter Wärmeentwicklung verfestigt. Eine andere Möglichkeit zur Formgebund besteht darin, das noch trockene oder lediglich mit z.B. Wasser angefeuchtete Siliciumpulver in eine Form einzubringen und erst dann mit dem für die Reaktionsbindung ausgewählten Agens zu versetzen. Die bei der Reaktion sich entwickelnde Wärme reicht gewöhnlich aus, um die vorhandene Feuchtigkeit zu verdampfen und das Reaktionsprodukt zum Trocknen zu bringen. Zusätzlich kann der Trocknungsprozeß durch externe Wärmeeinwirkung gefördert werden, wobei gewöhnlich nur Temperaturen unterhalb des Siedepunktes von Wasser nötig sind. Daneben kann anschließend eine, allerdings nicht zwingend vorgeschriebene, Wärmebehandlung durchgeführt werden. Auf diese Weise erhält man, entweder in Form eines noch weiter zu bearbeitenden Rohprodukts oder als Fertigprodukt Formkörper auf der Basis des nach dem erfindungsgemäßen Verfahren erhaltenen Werkstoffes.

Als Grundmaterial für das Verfahren dient Pulver aus elementarem oder legiertem Silicium. Die Reaktionsbindung läßt sich dabei selbst bei Pulvern in Gang bringen, die, wie beispielsweise Ferrosilicium der Formel FeSi einen unterhalb von 50 Gew.-% liegenden Siliciumanteil aufweisen. Ebenso kann aber auch reinstes Silicium von Halbleiterqualität nach dem erfindungsgemäßen Verfahren gebunden werden. Es ist damit möglich, entsprechend dem Verwendungszweck des herzustellenden Werkstoffes Siliciumpulver einer jeweils geeigneten Reinheitsstufe auszuwählen. So wird man etwa zu höchstreinem Siliciumpulver als Ausgangsmaterial greifen, wenn aus dem daraus hergestellten Werkstoff beispielsweise Reaktionsräume für Hochtemperaturprozesse, wie etwa Dotier- oder Epitaxievorgänge in der Halbleitertechnik gefertigt werden sollen. Andererseits kommt z.B. als Grundmaterials für Wärmedämmplatten bereits ein Werkstoff auf der Basis von erheblich weniger reinem Siliciumpulver in Frage. Der Werkstoff kann somit beispielsweise aus Pulvern aus Reinstsilicium mit weit über 99,99 Gew.-% Siliciumanteil, technischem Silicium mit bis zu 4 Gew.-% Verunreinigungen, aber auch aus siliciumhaltigen Legierungen erhalten werden, die z.B. in Form von verschiedenen Ferrosiliciumsorten mit ca. 45—48 Gew.%, 75—77 Gew.-% oder 92—94 Gew.-% Siliciumanteil, in Form von Calciumsilicium mit ca. 60 Gew.-% Siliciumanteil, oder in Form der als "Silumin" bezeichneten Silicium/Aluminium-Legierung mit typisch 5—15 Gew.-% Si-Anteil, in der Metallurgie gebräuchlich und kommerziell erhältlich sind. Selbstverständlich sind neben den hier beispielhaft genannten auch andere, elementare oder legierte Siliciumpulver als Ausgangsmaterialien möglich. Der Einfachheit halber wird im folgenden für die Palette derartiger geeigneter Ausgangsmaterialien der Ausdruck "Siliciumpulver" verwendet.

Das Verfahren zur Herstellung des Werkstoffes kann mit Siliciumpulver durchgeführt werden, dessen mittlere Korngröße innerhalb eines weiten Bereiches variierbar ist. Der Begriff "mittlere Korngröße" ist dabei so zu verstehen, daß 50 Gew.-% der Pulverteilchen im Vergleich zum angegebenen Wert kleinere oder gleiche und 50 Gew.-% eine größere oder gleiche Korngröße aufweisen. Somit ist die Anwesenheit beträchtlich kleinerer und beträchtlich größerer Teilchen nicht ausgeschlossen. Beispielsweise läßt sich selbst sehr feines Siliciumpulver von ca. 0,1 µm mittlerer Korngröße, aber auch grobes Siliciumpulver von ca. 500 µm mittlerer Korngröße binden. Prinzipiell ist auch der Einsatz von Pulversorten mit außerhalb dieser Grenzbereiche liegenden mittleren Korngrößen möglich; jedoch kann bei feineren Siliciumpulvern die Reaktionsbindung unter Aufschäumen und Bildung eines blasenhaltigen Produktes vor sich gehen, während gröbere Pulver oft ein zum Zerbröckeln neigendes, mechanisch wenig stabiles Produkt ergeben. Allgemein können durch die Auswahl einer entsprechenden mittleren Korngröße und entsprechender Korngrößenverteilung des Siliciumspulvers Eigenschaften wie Dichte, Porosität, thermische Leitfähigkeit, mechanische Stabilität und dergleichen variiert und den jeweiligen Erfordernissen angepaßt werden. Beispielsweise wird man als Grundmaterial für poröse Filterplatten eher grob gekörntes Siliciumpulver mit geringem Feinkornanteil verwenden, für dichtes und kompaktes Material, beispielsweise als Ausgangsmaterial für gasdichte Formkörper hingegen feinkörniges Siliciumpulver mit hoher Schüttdichte.

Siliciumpulver geeigneter mittlerer Korngröße, insbesondere im bevorzugten Bereich von 1—100 µm, kann beispielsweise durch Zermahlen des in grobstückiger Form erhältlichen Rohsiliciums in Kugel- oder Schwingmühlen gezielt erhalten werden. Geeignetes Ausgangsmaterial fällt auch in großem Maßstab beim Zerkleinern des für die Silanherstellung im Wirbelschichtverfahren verwendeten stückigen Rohsiliciums als sogenanntes "Unterkorn", an, d.h. als eine Pulverfraktion, die für den Einsatz in der Wirbelschicht zu fein ist und bisher zur Wiederverwendung in aufwendiger Weise erneut verschmolzen werden muß. Reinstes Siliciumpulver geeigneter mittlerer Korngröße kann beispielsweise in Prall- oder Luftstrahlmühlen erhalten werden, wo die Gefahr von Verunreinigungen besonders gering zu halten ist.

Eine weitere Möglichkeit, die Qualität und die erwünschten Eigenschaften des neuen Werkstoffes zu beeinflussen, liegt darin, dem Siliciumpulver Füllstoff beizumengen, wobei sich Art, Korngröße und Menge der geeigneten Füllstoffe innerhalb weiter Grenzen variieren lassen. Geeignete Füllstoffe sind beispielsweise Oxide, wie die des Siliciums, Aluminiums, Titans oder anderer Elemente, beispielsweise Quarz, Korund, Rutil, Anatas, Zirkonoxid oder dergleichen, sowie beispielsweise Mischoxide, wie etwa Ferrite, aber auch Pulver von Metallen, wie z.B. Eisen, Kupfer, Zink, Zinn, Aluminium oder Legierungen, wie etwa Messing. Daneben können auch Verbindungen wie z.B. Gips, Calciumcarbonat, Bariumsulfat, Hartstoffe, wie Titancarbid, Wolframcarbid, Siliciumcarbid, aber auch Boride, und Nitride, wie Bor- oder Siliciumnitrid sowie Graphit, ja selbst Sande, Stäube oder gemahlene Schlacke zugesetzt werden.

Der geeignete Bereich der mittleren Korngröße der jeweils zugesetzten Füllstoffe entspricht grundsätzlich dem auch für das vorgelegte Siliciumpulver geeigneten; allerdings braucht nicht notwendig jeweils eine gleiche mittlere Korngröße ausgewählt zu werden. So läßt sich z.B. ohne weiteres Siliciumpulver von ca. 3 µm mittlerer Korngröße mit Quarzpulver von etwa 100 µm mittlerer Korngröße binden. Umgekehrt kann aber durchaus auch beispielsweise Siliciumpulver der mittleren Korngröße 150 µm in Gegenwart von Rutilpulver der mittleren Korngröße 10 µm gebunden werden.

Auch das Mengenverhältnis des zugesetzten Füllstoffes zum vorgelegten Siliciumpulver kann innerhalb weiter Grenzen variiert werden. Selbst bei Zusatz von 50 Gew.-% Füllstoff und mehr, bezogen auf eingesetztes Silicium, verläuft gewöhnlich die Reaktion ohne Schwierigkeiten. Dadurch ergibt sich die Möglichkeit, Menge und Art des zuzusetzenden Füllstoffes je nach den geplanten Verwendungszweck des Werkstoffes auszuwählen und anzupassen. Beispielsweise läßt sich durch Zusatz von etwa 50 Gew.-% Quarzpulver oder Korundpulver, bezogen auf eingesetztes Silicium, die ohnehin beträchtliche Hochtemperaturbeständigkeit des Produktes weiter steigern, so daß es als Grundmaterial für z.B. Ofen- oder Kokillenauskleidungen, Wärmedämmplatten, Schmelztiegel oder dergleichen geeignet ist. Andererseits kann beispielsweise die elektrische und die Wärmeleitfähigkeit durch Zusatz von Metallpulvern gezielt beeinflußt werden. Angesichts der ungeheuren Vielzahl von Kombinationen in Bezug auf Art, Menge und Korngröße des Füllstoffes sowie des vorgelegten Siliciumpulvers stehen dem Fachmann zahlreiche andere Variationsmöglichkeiten zur Verfügung, durch welche jedoch der Grundgedanke der Erfindung nicht verlassen wird.

Auch die hier genannten Beispiele dienen lediglich der Illustration, nicht aber der Beschränkung des Erfindungsgedankens.

Wie für die Eigenschaften des eingesetzten Siliciumpulvers und der ggf. beigemengten Füllstoffe bestehen auch für das zum In-Gang-Bringen der Reaktionsbindung zugesetzte Agens breite Variationsmöglichkeiten. Grundsätzlich lassen sich alle von Alkalimetallverbindungen freien Agentien verwenden, die in der Lage sind, Silicium ätzend anzugreifen. Diese Eigenschaft besitzen beispielsweise

4

alkalische, wäßrige Systeme, aber auch saure, wäßrige System in Gegenwart von Oxidationsmitteln und selbst, wenn auch in geringem Maße, reines Wasser, Daneben sind auch einige organische System bekannt, die Silicium ätzen können, ebenso wie beispielsweise alkoholische alkalische von Alkalimetallverbindungen freie Systeme. Geeignete Agentien sind daher beispielsweise Wasser, wäßrige Lösungen von Hydroxyden der Erdalkalimetalle, oder andere von Alkalimetallverbindungen freie alkalisch reagierende wäßrige Salzlösungen, wie beispielsweise Carbonate. Will man ein möglichst reines Produkt erhalten, so kann vorteilhaft wäßrige Ammoniaklösung eingesetzt werden, da sich dieses Agens bei einer auf die Reaktionsbindung folgenden Temperaturbehandlung nahezu rückstandsfrei wieder vertreiben läßt. Neben wäßrigen alkalischen Systemen sind auch von Alkalimetallverbindungen freie alkoholische Lösungen geeignet. Auch durch Säuerbehandlung, insbesondere durch aufeinanderfolgende Behandlung mit Salpetersäure und Flußsäure oder einer Flußsäure/Salzsäure-Mischung kann die Reaktionsbindung in Gang gebracht werden. In diesem Zusammenhang sind auch die in der Halbleitertechnologie gebräuchlichen sauren Ätzmischungen zu nennen, wie beispielsweise die Polierätze CP4 auf Basis Salpetersäure/Flußsäure/Essigsäure (Holmes PJ Proc. Inst. Elekt. Engrs. B 106 (Suppl. 17), 861 (1959)). Derartige Säurebehandlungen erfordern allerdings höhere Konzentrationen und können insbesondere im Zusammenhang mit Siliciden zur unerwünschten Bildung der zur Selbstentzündung neigenden Silane führen. Die gleichfalls grundsätzlich mögliche Anwendung von Ätmischungen auf organischer Basis, wie eta Hydrazin/Brenzcatechin-Mischungen, kommt schon aus Kostengründen für eine breitere Anwendung kaum in Frage. Gemeinhin läßt sich durch wenige Vorversuche ermitteln, ob zum Binden des gewählten Siliciumpulvers und ggf. des beigemengten Füllstoffes konzentrierte, verdünnte oder stark verdünnte Lösungen ausreichen. Schon aus Gründen der Wirtschaftlichkeit wird dabei natürlich der Einsatz möglichst niedrigkonzentrierter Agentien angestrebt werden.

Das Verfahren zur Herstellung des Werkstoffes wird zweckmäßig in der Weise durchgeführt, daß die ausgewählten Komponenten, also das Siliciumpulver, ggf. mit dem Füllstoff, sowie das die Reaktionsbindung in Gang bringende Agens miteinander vermischt werden. Gewöhnlich genügt es bereits, wenn das Agens in einer Menge zugegeben wird, die ausreicht, um das Siliciumpulver gleichmäßig zu befeuchten. Zu diesem Zweck kann dem Pulver unter Rühren nach und nach das Agens zugegeben werden, bis eine Mischung breiartiger Konsistenz entstanden ist, die sich gut formen läßt. Das Rühren kann dabei von Hand oder maschinell erfolgen. Eine andere Möglichkeit des Vermischens besteht darin, das Agens durch das ggf. in einer Form befindliche trockene oder angefeuchtete Siliciumpulver lediglich durchlaufen zu lassen, es mittels Vakuum durchzusaugen oder unter Druck, beispielsweise mittels Preßluft oder Inertgas, durchzupressen.

Ein erster Formgebungsschritt kann in der Weise durchgeführt werden, daß das noch trockene Siliciumpulver zunächst in eine Form eingebracht wird, und danach die Zugabe des die Reaktionsbindung in Gang bringenden Agens erfolgt. Dabei ist allerdings die Gefähr zu beachten, daß das Siliciumpulver unter Umständen ungleichmäßig mit dem Agens befeuchtet werden kann und dementsprechend ungleichmäßig bindet. Eine andere Möglichkeit liegt darin, das Siliciumpulver zunächst mit einer Flüssigkeit anzufeuchten, die die Reaktionsbindung nicht oder nur langsam in Gang zu bringen vermag, wie etwa Alkohol oder reines Wasser, diese Mischung in die gewünschte Form einzubringen und dann das eigentliche Agens zuzufügen. Nach einer besonders günstigen Ausführungsform des erfindungsgemäßen Verfahrens ist es jedoch vorteilhaft, das Siliciumpulver außerhalb der Form mit einem Agens anzufeuchten, dessen Konzentration so gewählt ist, daß die Reaktion nicht sofort, sondern erst nach einer gewissen Zeit einsetzt und sich selbst trägt. In dieser Zeit hat man nämlich eine weitere Möglichkeit, auf die Masse aus Siliciumpulver und Agens formend einzuwirken. Dies kann beispielsweise dadurch geschehen, daß die Masse auf einer geeigneten Unterlage, beispielsweise Glas-, Metall- oder Kunststoffplatten, Filtertüchern oder Filterpapier zu einem flächenhaften Gebilde verstrichen wird. Eine andere Möglichkeit besteht darin, die Masse in Formen einzubringen, beispielsweise einzugießen, etwa mittels Schleuder- oder Spritzguß, einzustampfen oder einzupressen, welche günstig bereits in der Gestalt des erwünschten Produktes ausgebildet sind, um z.B. Hohlkörper, wie Rohre oder Hohltiegel, aber auch massive Körper, wie Blöcke, Dünn- oder Dickstäbe, Platten oder andere Formkörper unterschiedlichster Art zu erhalten.

Wichtig ist es, ein Entweichen der bei der Reaktionsbindung auftretenden Gase, insbesondere Wasserdampf und in geringerem Maß Wasserstoff, zu ermöglichen; zu diesem Zweck empfiehlt es sich, beispielsweise poröse Hohlformen zu verwenden oder sie mit Schlitzen oder andersartigen Öffnungen zu versehen, durch die zwar die Gase austreten können, nicht aber die noch nicht gebundene Masse. Grundsätzlich ist auch die Verwendung dichter Formen mit Gasabzugsmöglichkeit, beispielsweise einseitig offener oder mit einer gasdurchlässigen Abdeckung versehener Hohlformen nicht auszuschließen, da wegen der Porosität des erfindungsgemäßen Werkstoffes im allgemeinen auch aus solchen Formen die beim Binden entstehenden Gase entweichen können. Wenn eine stark poröse Konsistenz des Werkstoffes angestrebt wird, kann die Gasentwicklung während des Bindens zum Aufblählen des Werkstoffes benutzt werden. Zu diesem Zweck ist es günstig, vor dem Binden für einen hohen Restfeuchtanteil zu sorgen. Ein besonderer Vorteil beim Formen der zu bindenden Masse liegt darin, daß beispielsweise große Hohlformen sich auch in mehreren Etappen füllen lassen, wobei auch jeweils nach Abschluß der Reaktionsbindung der vorhergehenden Teilfüllung die nächste Teilfüllung eingebracht werden kann. Die einzelnen Chargen verbinden sich untereinander problemlos, so daß sich auch komplizierte Formkörper durch Verbinden von verschiedenen Einzelelementen herstellen lassen.

Wird eine besonders kompakte, dichte Konsistenz des erfindungsgemäßen Werkstoffes gewunscht, so hat es sich bewährt, den ersten Formgebungsschritt unter Druckeinwirkung durchzuführen. Dazu eignen sich grundsätzlich Vorrichtungen, in denen formbare Massen durch Druck in eine bestimmte Form gebracht oder aber vorgeformte Massen durch Druck verdichtet werden können. Solche Vorrichtungen sind zum Beispiel in der keramischen Industrie zum Pressen von Platten, Ziegeln, Tiegeln und anderen Formkörpern gebräuchlich und lassen sich entsprechend auch zum Pressen des erfindungsgemäßen Werkstoffes während der Reaktionsbindung einsetzen. Dabei genügt in der Regel eine kurzzeitige Einwirkung des Druckes, meist von wenigen Sekunden, bevorzugt in der Anfangsphase der Reaktionsbindung, um einen dichten und in seiner mechanischen Stabilität, z.B. Druckfestigkeit, gegenüber ungepreßtem Material verbesserten Werkstoff zu erhalten. Der verwendete druck kann im allgemeinen in dem Bereich variiert werden, für den die jeweils vorgegebene Presse ausgelegt ist, wobei höherer Druck eine größere Dichte des Produktes bewirkt. Gate Ergebnisse wurden in einem Druckbereich bis zu etwa 30 MPa (300 bar) erzielt. Weiter hat es sich als günstig erwiesen, daß sich die Formkörper auch durch mehrere aufeinander folgende Preßvorgänge etappenweise formen lassen, wodurch selbst kompliziert geformte Produkte zugänglich werden.

In einer zweckmäßigen Ausgestaltung des Verfahrens zur Herstellung des Werkstoffes werden die verschiedenen Reaktionsparameter, wie Art und Korngröße des Siliciumpulvers sowie ggf. des Füllstoffes, und Art und Konzentration des zuzusetzenden, die Reaktionsbindung in Gang setzenden Agens so aufeinander abgestimmt, daß die Reaktion nicht sofort einsetzt, sondern erst nach einer Zeitspanne, die es gestattet, den erforderlichen Formprozeß ohne Beeinträchtigung abzuschließen. Das Einsetzen der Reaktionsbindung läßt sich daran erkennen, daß die Temperatur des Gemisches aus Siliciumpulver und Agens ansteigt. Häufig ist mit diesem Temperaturanstieg auch eine Gasentwicklung verbunden, die beispielsweise im Falle wäßriger Agentien neben Wasserstoffbildung hauptsächlich von verdampfendem Wasser herrührt.

Ein besonders günstiges und im Rahmen des Herstellungsverfahrens bevorzugtes Mittel zur Steuerung der zwischen dem Vermischen der Komponenten und dem Einsetzen der Reaktionsbindung liegenden Zeitspanne, der sogenannten "Topfzeit", besteht darin, nach Abschluß des Formprozesses die Masse einer erhöhten Temperatur auszusetzen. Dabei genügt gewöhnlich der Bereich zwischen einer gegenüber der Raumtemperatur geringfügig erhöhten Temperatur und dem Siedepunkt des verwendeten Agens; der prinzipiell möglichen und nicht ausgeschlossenen Anwendung höherer Temperaturen bedarf es in der Regel nicht. Besonders bewährt hat sich bei wäßrigen Agentien ein Temperaturbereich von 70 bis 90°C. Die Anwendung erhöhter Temperatur kann beispielsweise in der Art erfolgen, daß Warmluft Mittels eines Gebläses über oder durch die z.B. zu Platten vorgeformte Masse geleitet wird. Weiterhin kann die vorgeformte Masse, ggf. mitsamt der Form, in einem geeigneten Ofen, etwa einem Trockenschrank, einem Anlaß- oder einem Warmluftofen erhöhter Temperatur ausgesetzt werden; auch der Einsatz von Mikrowellen ist denkbar. Ferner besteht die Möglichkeit, heizbare Formen vorzusehen, deren Wände entweder von einem Heizmittel, wie beispielsweise heißem Wasser oder Dampf, durchströmt werden können, oder aber die elektrisch oder durch Gasbrenner beheizbar sind. Durch die erhöhte Temperatur wird erreicht, daß in der Regel innerhalb weniger Minuten die Reaktionsbindung in Gang kommt, und daß sich auch Mischungen, die bei Raumtemperatur nicht oder nur träge binden, zur Reaktion bringen lassen. Ein Vorteil der erhöhten Temperatur liegt auch darin, daß die bindende Mischung rascher und zuverlässiger als bei Raumtemperatur zur Trocknung gebracht wird.

Als Endprodukt der Reaktionsbindung und ggf. des Trockenprozesses steht dann der erhaltene Werkstoff in Form eines mechanisch stabilen Gefüges der eingesetzten Pulverteilchen zur Verfügung und kann nun entweder seiner geplanten Verwendung zugeführt oder durch weiterführende, geeignete Nachbehandlung veredelt werden.

Eigenschaften wie beispielsweise mechanische Stabilität, Härte, Bruchfestigkeit, Hochtemperaturbeständigkeit oder dergleichen lassen sich durch Wärmebehandlung des Werkstoffes günstig beeinflussen. Bereits z.B. eine 5- bis 15-minütige kurzzeitige Wärmebehandlung bei etwa 200°C bewirkt in der Regel eine merkliche Verfestigung. Noch deutlicher wird die Verfestigung, wenn der Werkstoff einer Temperatur im Glühbereich, also ab etwa 600—700°C, ausgesetzt wird. Obwohl es bei einer solchen hochtemperaturbeständigen Werkstoffzusammensetzung prinzipiell möglich ist, die Temperatur vor allem bei kurzzeitiger Wärmebehandlung auch über die Schmelztemperatur von Silicium hinaus zu steigern, wird man jedoch schon aus wirtschaftlichen Gründen eine möglichst niedere Temperatur anstreben. Gute Resultate können beispielsweise im Temperaturbereich von 600—1200°C erhalten werden.

Selbstverständlich bleibt die Wahl des Füllstoffs nicht ohne Einfluß auf den für die Wärmebehandlung möglichen Temperaturbereich. Beispielsweise gestattet ein aus Silicium- und Quarzpulver im Gewichtsverhältnis 1:1 hergestellter Werkstoff Tempervorgänge deutlich oberhalb der Schmelztemperatur von Silicium.

Die Wärmebehandlung kann wegen der Temperaturschockbeständigkeit des Werkstoffes in der Weise durchgeführt werden, daß der Werkstoff direkt der gewählten Temperatur ausgesetzt wird. Auch die anschließende Abkühlung erfordert keine besonderen Vorsichtsmaßnahmen. In diesem Zusammenhang ist es besonders günstig, daß die Wärmebehandlung nicht eine, zwar grundsätzlich mögliche, Inertgasatmosphäre erfordert, sondern im Gegenteil mit besonders gutem Erfolg in Luft durchgeführt werden kann. Somit können neben gängigen Öfen, wie etwa Muffel-, Tiegel- oder Kammeröfen

6

beispielsweise auch in der keramischen Industrie gebräuchliche Ofenarten eingesetzt werden; geeignet sind z.B. offen gebaute Öfen, die von dem zu behandelnden Gegenstand unter Luftzutritt durchlaufen werden. Die Wärmebehandlung erfordert in der Regel nur etwa 5 bis 15 Minuten, obwohl prinzipiell kürzere oder längere Zeiten nicht ausgeschlossen werden sollen.

Eine solche Wärmebehandlung kann grundsätzlich auch unmittelbar an das Vermischen des Siliciumpulvers mit dem Agens angeschlossen werden. Damit besteht, insbesondere bei kleinen Formteilen, die Möglichkeit, die Reaktionsbindung und die Wärmebehandlung in einem Prozeßschritt durchzuführen.

Ein Vorteil des durch das erfindungsgemäße Verfahren hergestellten Werkstoffes liegt in seiner leichten mechanischen Bearbeitbarkeit, die es auf einfache Weise gestattet, beispielsweise durch Vergießen in eine Form vorgeformte Werkstoffteile weiter zu bearbeiten, oder aber aus Rohlingen, wie beispielsweise Blöcken oder Stäben, Formteile herauszuarbeiten. Eine solche formgebende Bearbeitung kann sowohl nach der Reaktionsbindung als auch im Anschluß an eine ggf. vorgenommene Wärmebehandlung stattfinden. Der Werkstoff ist von den Bearbeitungsmöglichkeiten her in etwa mit Graphit oder manchen keramischen Materialien vergleichbar. Dementsprechend kann er beispielsweise gesägt, geschliffen, gedreht oder gebohrt werden und bietet damit eine Vielzahl von Möglichkeiten zur Formgebung.

Eine weitere, sehr wichtige Möglichkeit zur Nachbehandlung des Werkstoffes liegt in der Veredelung seiner (inneren und äußeren) Oberfläche durch Erzeugen von Oberflächenschichten verschiedenster Art. Beispielsweise kann durch kurzzeitige Hochtemperaturbehandlung, etwa vermittels Strahlungs- oder Flammenheizung, der Werkstoff oberflächlich zum Aufschmelzen gebracht werden. Dadurch bildet sich eine glatte, dichte Oberflächenschicht aus, deren Dicke nach Zeitdauer der Hochtemperaturbehandlung den Bereich von wenigen Mikrometern bis zu mehreren Millimetern umfassen kann. Eine derartige Oberflächenbehandlung genügt in der Regel, um den Werkstoff gasdicht und damit anwendbar bei Gasreaktoren, Zuleitungen, Gasrohren, Tiegeln und dergleichen zu machen.

Daneben bestehet aber auch die Möglichkeit, zusätzliche Oberflächenschichten auf aus dem Werkstoff gefertigte Formkörper aufzubringen. Besonders einfach kann dies durch Aufspritzen, mechanisches Auftragen oder auch durch Eintauchen in eine entsprechende Schmelze des ausgewählten Beschichtungsmaterials geschehen. Beispielsweise kann ein aus Reinstsiliciumpulver reaktionsgebundener Formkörper durch Eintauchen in eine Reinstsiliciumschmelze von etwa 1450—1500°C mit einem Überzug aus Reinstsilicium versehen werden. Prinzipiell lassen sich durch Eintauchen in Reinstsiliciumschmelzen jedoch auch Formkörper aus weniger reinem Grundmaterial verwendbar für höchste Reinheit erfordernde Prozesse machen.

Schichten aus Silicium oder anderen geeigneten Materialien lassen sich auch durch Beschichtung aus der Gasphase auf den Werkstoff aufbringen, und zwar sowohl durch Abscheidung des Beschichtungsstoffes aus der Gasphase als auch durch Reaktion des Werkstoffes mit der Gasphase unter Bildung einer neuen Oberflächenschicht. Beispiele für eine Beschichtung durch Abscheidung sind die Zersetzung von Siliciumhalogeniden. Borhalgeniden oder Kohlenwasserstoffen auf erhitzten Substraten aus dem neuen Werkstoff, durch welche diese sich mit Schichten aus Silicium, Bor oder Kohlenstoff überziehen lassen. Solche Beschichtungsverfahren, die selbstverständlich nicht auf die hier genannten Beispiele beschränkt sind, sind in der Beschichtungstechnik auch für andere Substrate bekannt und gebräuchlich. Dies gilt auch für die Möglichkeit, durch Reaktion mit einer Gasphase auf aus dem Werkstoff gefertigte Substrate Beschichtungen aufzubringen. Aus der Vielfalt der möglichen Anwendungen seien hier beispielsweise Nitridierung durch Überströmen oder durch Durchströmen des porösen erfindungsgemäßen Werkstoffs mit Ammoniak oder Stickstoff bei hohen Temperaturen, die Oxidation mit beispielsweise feuchtem Sauerstoff oder auch die Carbidbildung vermittels Kohlenwasserstoffen genannt. Diese Verfahren sind für die Oberflächenbehandlung von mono- oder polykristallinem, elementarem Silicium bekannt und lassen sich sinngemäß auf das erfindungsgemäß gebundene Siliciumpulver übertragen.

Damit läßt sich der durch das erfindungsgemäße Verfahren hergestellte Werkstoff durch die Wahl der Ausgangsstoffe, durch die Bedingungen der Reaktionsbindung und durch Wärmebehandlung und/oder Beschichten sowie dank seiner leichten Bearbeitbarkeit in seinen Eigenschaften und seiner Form innerhalb weiter Grenzen variieren. Entsprechend vielfältig sind auch die Anwendungsmöglichkeiten, von denen nachstehend nur beispielhaft einige genannt seien. Beispielsweise ist der Werkstoff, mit einer Beschichtung aus Reinstsilicium versehen, in vielen Fällen anstelle von polykristallinem Silicium einsetzbar, sei es beispielsweise als Trägerkörper bei der Siliciumabscheidung durch thermische Zersetzung von Silanen, sei es für Reaktionsräume bei Hochtemperaturprozessen in der Halbleitertechnik. Als hochfeuerfestes und chemisch resistentes Material ist der Werkstoff ein ausgezeichneter Wärmeisolierstoff und kann beispielsweise zur Auskleidung von Öfen oder Tiegeln oder auch als Gießform verwendet werden. Die Reaktionsbindung läßt sich auch beispielsweise durch erneutes Durchfeuchten mit Agens vor einer Wärmebehandlung leicht wieder auflösen. Das Überführen eingeschlossener Gußkerne aus dem Werkstoff in aufgeschlämmtes Pulver oder auch die Herstellung dünner Schichten oder dünnwandiger Körper durch Beschichten des Werkstoffs und nachfolgendes ganzes oder teilweises "Auflösen" des als Substratkörper wirkenden Werkstoffs ist dadurch ohne weiteres möglich.

Nach letztgenannter Verfahrensweise lassen sich beispielsweise Siliciumfolien für Solarzellen dadurch

# EP 0 105 463 B1

gewinnen, daß Platten oder Bänder aus dem Werkstoff beispielsweise einseitig mit einer zusammenhängenden Siliciumschicht versehen werden und die genannten Platten oder Bänder, die als Substratkörper Verwendung fanden, nachfolgend wieder in die Pulverform überführt werden.

Aufgrund der hohen mechanischen Stabilität ist selbst eine Verwendung als Baustoff denkbar, während die Porosität den Einstaz als Filtermaterial ermöglicht. Ein weiteres Anwendungsgebiet liegt im Kompaktieren, insbesondere Pelletieren, beispielsweise von Siliciumfeinstäuben. Eine interessante Anwendung erwächst aus der Tatsache, daß sich Siliciumteile durch eine reaktionsbindende Zwischenschicht miteinander verbinden, gleichsam "verkleben" lassen. Zu diesem Zweck werden die Kontaktflächen der zu verbindenden Teile mit einer noch nicht durchreagierten Mischung aus zweckmäßig feinem Siliciumpulver und Agens eingestrichen und dann zusammengefügt. Insbesondere bei Unterstützung durch Temperaturerhöhung wird durch die Reaktionsbindung dann eine feste Verbindung der Einzelteile hergestellt. Auf diese Weise lassen sich insbesondere auch größere, sonst schwer erhältliche Formkörper aus entsprechend geformten Siliciumbauteilen zusammensetzen. Nicht zuletzt sei hier auch auf die Einsatzmöglichkeit als Substratkörper bei verschiedenen Beschichtungs- und Abscheideprozessen verwiesen.

Der erfindungsgemäße Werkstoff bietet somit die Möglichkeit, aus Siliciumpulver als Grundmaterial Formkörper unterschiedlichster Art für vielseitigste Verwendungszwecke herzustellen. Besonders vorteilhaft ist in diesem Zusammenhang, daß das Binden des Pulvers auf chemischem Wege im Gegensatz beispielsweise zu den hohe Temperaturen erfordernden Sinterprozessen bei deutlich niedrigeren Temperaturen durchgeführt werden kann.

Beispiel 1

Verschiedene Siliciumpulver der nachstehend angegebenen Zusammensetzung und mittleren Korngröße, die ggf. mit einem Füllstoff vermengt waren, wurden in eine zylindrische Hohlform von 2,5 cm Höhe und 2 cm Durchmesser eingebracht, die mit einer Vakuumanlage verbunden war. Anschließend wurde das jeweils ausgewählte Agens durchgesaugt, bis das Pulver gleichmäßig benetzt war. Die resultierenden Formkörper wurden zum beschleunigten Durchreagieren in einen Trockenschrank bzw. Muffelofen (Versuch 6) einer erhöhten Temperatur ausgesetzt. Nach wenigen Minuten war die Bindereaktion so weit fortgeschritten, daß sich dem Trockenschrank ein fester massiver Zylinder entnehmen ließ. Die den einzelnen Ansätzen entsprechenden Zahlenangaben sind in der Tabelle 1 zusammengefaßt.

TABELLE 1

| Versuch | Si-Pulver | Si-Anteil (Gew.-%) | Mittlere Korngröße (µm) | Füllstoff | Mittlere Korngröße (µm) | Gewichts-verhältnis Si-Pulver/ Füllstoff | Temperatur | Agens |
|---|---|---|---|---|---|---|---|---|
| 1 | Reinst-Si | 99,9999 | 5 | — | — | — | 80°C | 5 Gew.-% $NH_3$/$H_2O$ |
| 2 | Reinst-Si | 99,9999 | 15 | — | — | — | 800°C | 6,5 Gew.-% $HNO_3$<br>8 Gew.-% HCl<br>4 Gew.-% HF<br>$H_2O$ |
| 3 | Rein-Si | 99,99 | 40 | — | — | — | 80°C | 10 Gew.-Teile<br>15 Gew.-% Hydra-zin/$H_2O$<br>1 Gew.-Teil Brenzcatechin |

Beispiel 2

Ein gemäß Beispiel 1, Versuch 1, hergestellter Zylinder wurde 20 Stunden in einer Wasserstoff/ Stickstoffatmosphäre ($H_2$:$N_2$=20:80 Vol-% auf 1350°C erhitzt. Der danach erhaltene Zylinder war vollständig nitridiert.

Beispiel 3

500 g eines Pulvers aus Reinstsilicium mit einer mittleren Korngröße von 3,5 µm wurden nach und nach unter Rühren mit 5 Gew.-%-iger wäßriger $NH_3$-Lösung versetzt, bis eine teigartige, gleichmäßig durchfeuchtete Masse entstanden war. Diese Masse wurde in eine gasdurchlässige Hohlform in Form zweier ineinandergestellter Rohre mit 1 cm Wandabstand, 5 cm Außendurchmesser des Innenrohres und 20 cm Höhe eingebracht. Die gefüllte Form wurde in einen Trockenschrank bei 80°C eingestellt. Nach Entfernen der Hohlform nach 10 Minuten wurde ein poröses, stabiles Rohr aus reaktionsgebundenem Siliciumpulver erhalten. Dieses Rohr wurde an der Inennseite mit der vorbeigeführten Flamme eines Wasserstoffbrenners bis in eine Schichttiefe von ca. 200 µm angeschmolzen. Das erhaltene, an der Innenwandung oberflächenverschmolzene Rohr war gasdicht.

Beispiel 4

Zwei Rohre aus polykristallinem Silicium (Länge 500 mm, Durchmesser 100 mm, Wandstärke 6 mm) wurden jeweils an der Stirnfläche fettfrei gemacht. Dann wurde eine aus Reinstsiliciumpulver der mittleren Korngröße 3,5 µm und 5 Gew.-%-igem, wäßrigem Ammoniak angerührte Paste dünn aufgetragen. Die Rohre wurden anschließend mit den Stirnflächen zusammengedrückt und 10 Minuten bei 80°C im Trockenschrank belassen. Danach waren die beiden Rohre fest miteinander verbunden.

Beispiel 5

17,5 kg Rohsilicium (98 Gew.-% Siliciumanteil) wurden in einer Schwingmühle mit Stahlmahlkörper unter Wasserzusatz naß gemahlen, bis eine mittlere Korngröße von 20 µm erreicht war. Die erhaltene Masse wurde durch Dekantieren bis auf ca. 30 Gew.-% Wasseranteil ("Restfeuchte") entwässert und in eine mit einem gasdurchlässigen Deckel verschlossene gasdichte Stahlblechform der Maß 25×25×50 cm³ eingefüllt, so daß diese etwa halbvoll war. Kurze Zeit nach dem Einstellen der Form in einen auf 80°C aufgeheizten Ofen setzte die Reaktion ein, in deren Verlauf die Masse unter Aufschäumen die gesamte Form ausfüllte: Nach 15 Minuten konnte ein fester Block der oben angegebenen Maß entnommen werden.

**Patentansprüche**

1. Verfahren zur Herstellung eines Werkstoffes auf Basis von Silicium oder Siliciumlegierungen, bei dem ein Pulver aus elementarem oder legiertem Silicium einer Reaktionsbindung unterworfen wird, dadurch gekennzeichnet, daß das Pulver zum In-Gang-Bringen einer sich selbst unterhaltenden Reaktionsbindung mit einem Silicium ätzenden, von Alkalimetallverbindungen freien Agens angefeuchtet wird.

2. Verfahren nach Anspruch 1, dadurch gekennzeichnet, daß als Silicium ätzendes Agens wäßrige Ammoniaklösung oder Wasser eingesetzt wird.

3. Verfahren nach den Ansprüche 1 oder 2, dadurch gekennzeichnet, daß dem Siliciumpulver Füllstoff zugesetzt wird.

4. Verfahren nach Anspruch 3, dadurch gekennzeichnet, daß dem Siliciumpulver Quarz als Füllstoff zugesetzt wird.

5. Verfahren nach einem oder mehreren der Ansprüche 1—4, dadurch gekennzeichnet, daß die Mischung aus Pulver und Agens vor der Temperatureinwirkung einem ersten Formgebungsschritt unter Druckeinwirkung unterworfen wird.

6. Verfahren nach einem oder mehreren der Ansprüche 1—5, dadurch gekennzeichnet, daß der bereits gebundene Werkstoff einer zusätzlichen Wärmebehandlung bei 600—1200°C ausgesetzt wird.

7. Verfahren nach einem oder mehreren der Ansprüche 1—6, dadurch gekennzeichnet, daß der bereits gebundene Werkstoff nachträglich mit einer Oberflächenbeschichtung versehen wird.

**Revendications**

1. Procédé pour préparer un matériau à base de silicium ou d'alliages de silicium, selon lequel on soumet une poudre de silicium élémentaire ou allié à une liaison avec réaction, procédé caractérisé en ce que, pour déclencher une liaison avec une réaction s'entretenant d'elle-même, on humecte la poudre avec un agent capable d'attaquer le silicium et qui est dépourvu de composés de métaux alcalins.

2. Procédé selon la revendication 1, caractérisé en ce que l'on utilise, comme agent capable d'attaquer le silicium, une solution aqueuse d'ammoniac ou de l'eau.

3. Procédé selon les revendications 1 ou 2, caractérisé en ce qu'on ajoute à la poudre de silicium une charge.

4. Procédé selon la revendication 3, caractérisé en ce qu'on ajoute à la poudre de silicium du quartz comme charge.

5. Procédé selon une ou plusieurs des revendications 1 à 4, caractérisé en ce qu'avant de faire agir la température sur un mélange de la poudre et de l'agent, on soumet le mélange à une première étape de formage sous l'effet d'une compression.

6. Procédé selon une ou plusieurs des revendications 1 à 5, caractérisé en ce qu'on soumet le matériau, déjà lié, à un traitement supplémentaire de chauffage à 600—1200°C.

7. Procédé selon une ou plusieurs des revendications 1 à 6, caractérisé en ce que le matériau déjà lié est muni ultérieurement d'un revêtement de surface.

**Claims**

1. Process for manufacturing a material based on silicon or silicon alloys, in which process a powder composed of elemental or alloyed silicon is subjected to a reaction bonding, characterised in that, in order to initiate self-sustaining reaction bonding, the powder is moistened with a silicon-etching agent free from alkali-metal compounds.

2. Process according to Claim 1, characterised in that aqueous ammonia solution or water is used as the silicon-etching agent.

3. Process according to Claims 1 or 2, characterised in that filler is added to the silicon powder.

4. Process according to Claim 3, characterised in that quartz is added to the silicon powder as the filler.

5. Process according to one or more of Claims 1—4, characterised in that the mixture of powder and agent is subjected to a first shaping step under the action of pressure before the exposure to temperature.

6. Process according to one or more of Claims 1 to 5, characterised in that the already bonded material is subjected to an additional heat treatment at from 600 to 1200°C.

7. Process according to one or more of Claims 1 to 6, characterised in that the already bonded material is subsequently provided with a surface coating.